# EUROPEAN PATENT APPLICATION

(11) **EP 2 926 955 A1**
(43) Date of publication of application: **07.10.2015**
(21) Application number: 12889011.8
(22) Date of filing: 30.11.2012
(51) Int. Cl.: B25J 9/22, H05K 3/34

(54) **ROBOTIC SYSTEM**

(71) Applicant: Kabushiki Kaisha Yaskawa Denki, Kitakyushu-shi, Fukuoka 806-0004 (JP)
(72) Inventor: SHIINO, Takashi, Kitakyushu-shi Fukuoka 806-0004 (JP); URABE, Katsunori, Kitakyushu-shi Fukuoka 806-0004 (JP); IKENAGA, Takahisa, Kitakyushu-shi Fukuoka 806-0004 (JP); HARADA, Toshiyuki, Kitakyushu-shi Fukuoka 806-0004 (JP)
(74) Representative: Grünecker Patent- und Rechtsanwälte PartG mbB
(86) International application number: PCT/JP2012/081146
(87) International publication number: WO 2014/083695

(57) **Abstract**

A robot system (1) according to an aspect of an embodiment includes a touch panel (display device) (81), a camera (70), a tape position identification unit (identification unit) (61d), a fine adjustment unit (81a), and an instruction unit (61g). The camera (70) captures images of a workpiece (W) with and without a member thereon to be handled by a robot. The tape position identification unit (61d) identifies a position of the member based on image data captured by the camera (70). The fine adjustment unit (81a) is provided as an interface by which an operator conducts a fine adjustment of a teaching point for the robot based on the position of the member while viewing the workpiece (W) displayed on the touch panel (81). The instruction unit (61g) instructs the robot to perform an operation for a predetermined process on the basis of teaching information (62c) generated by reflecting the teaching point finely adjusted through the fine adjustment unit (81a).

## Description

### Field

Embodiments disclosed herein relate to a robot system.

### Background

Conventionally, various kinds of robot system, which perform a predetermined process operation for a workpiece to be processed (hereinafter, referred to as "workpiece"), are employed in such as a production line of a subject to be processed, so that improvement of efficiency of the production line is achieved.

In those robot system, it is necessary for the robot system to be conducted a teaching operation (hereinafter, referred to as "teaching"). However, since the teaching is an operation that requires a long time to conduct, even for a skilled operator, it is desired to make more improvement from points of view of a human resource and a time consuming.

Therefore, several methods in order to make an improvement in efficiency of the teaching have been suggested (for, example, see patent literature 1). The device disclosed in the patent literature performs acquiring a plane view image of a workpiece and displaying it, designating and inputting any points on the image displayed, obtaining coordinates of the designated points as a data that indicates a trajectory of a tool device, and converting the data to teaching data of a robot and storing it.

### Citation List

### Patent Literature

Patent Literature 1: Japanese Laid-open Patent Publication No. 1995-308878

Summary

### Technical Problem

There are still things to improve for achieving both of efficiency and accuracy of the teaching, and a reliability of a process operation using the robot.

For example, the robot handles many kinds of aspects of the workpiece. Furthermore, regardless of such many kinds of aspects of the workpiece, it is required for the robot to always accurately operate and certainly perform a predetermined process operation.

Accordingly, in actual teaching, it is often the case that it is required to conduct a fine adjustment in accordance with each of aspects of the workpiece. In this regards, the teaching device above mentioned shall repeat a further teaching after deleting prior reaching data if the prior teaching is misconducted, so it is not enough to meet the needs for the efficiency in teaching.

In addition, even if accurate and efficient teaching is conducted, in such a case that a subject to be processed includes for example a masking tape which unstably curls after peeling off, adhering the masking tape to a workpiece and other portions of the device leads to decrease of certainty of processing operation, and thus it is nonsense.

The object of one aspect of embodiments is to achieve improvement in both efficiency and accuracy of the teaching, and a reliability of a process operation using the robot.

### Solution to Problem

A robot system according to an aspect of an embodiment includes a display device, a camera, an identification unit, a fine adjustment unit, and an instruction unit. The camera captures an image of a workpiece with a member thereon and an image of the workpiece without the member thereon, the member being a target to be handled by a robot. The identification unit is configured to identify a position of the member on the basis of image data captured by the camera. The fine adjustment unit is provided as an interface by which an operator conducts a fine adjustment of a teaching point for the robot based on the position of the member while viewing the workpiece displayed on the display device. The instruction unit is configured to instruct the robot to perform an operation for a predetermined process on the basis of teaching information generated by reflecting the teaching point finely adjusted through the fine adjustment unit.

### Advantageous Effects of Invention

According to an aspect of an embodiment, it is possible to achieve improvement in both efficiency and accuracy of the teaching, and a reliability of a process operation using the robot.

### Brief Description of Drawings

FIG. 1A is a schematic plane view illustrating entire construction of a robot system according to an embodiment.
FIG. 1B is a schematic diagram of a workpiece.
FIG. 2 is a block diagram of a robot system according to the embodiment.
FIG. 3A is a schematic side view illustrating a construction of a transportation unit.
FIG. 3B is a schematic side view illustrating a construction of a transportation unit.
FIG. 4A is a schematic plane view illustrating an operation of the transportation unit of the robot system.
FIG. 4B is a schematic plane view illustrating an operation of the transportation unit of the robot system.
FIG. 5 is a schematic side view illustrating a construction of a first robot.
FIG. 6A is a schematic front view illustrating a construction of a hand of a first robot.
FIG. 6B is a schematic perspective view illustrating a construction of a hand of a first robot.
FIG. 7A is a schematic plane view illustrating a construction of a tape storage unit.
FIG. 7B is a schematic side view illustrating a construction of a tape storage unit.
FIG. 8A is a schematic diagram (part1) illustrating an operation of the first robot and a gripping mechanism.
FIG. 8B is a schematic diagram (part2) illustrating an operation of the first robot and a gripping mechanism.
FIG. 8C is a schematic diagram (part3) illustrating an operation of the first robot and a gripping mechanism.
FIG. 8D is a schematic diagram (part4) illustrating an operation of the first robot and a gripping mechanism.
FIG. 8E is a schematic diagram (part5) illustrating an operation of the first robot and a gripping mechanism.
FIG. 8F is a schematic diagram (part6) illustrating an operation of the first robot and a gripping mechanism.
FIG. 8G is a schematic diagram (part7) illustrating an operation of the first robot and a gripping mechanism.
FIG. 9A is a schematic perspective view illustrating a construction of a control panel.
FIG. 9B is a flowchart illustrating an operation flow of a teaching according to the embodiment.
FIG. 10A is an exemplary diagram of a main screen.
FIG. 10B is an exemplary diagram of a screen of workpiece information registration.
FIG. 10C is an exemplary diagram of a screen of job generation.
FIG. 10D is a schematic diagram illustrating a position of division.
FIG. 10E is an exemplary diagram (part1) of a screen of an operation content setting.
FIG. 10F is an exemplary diagram (part2) of a screen of an operation content setting.
FIG. 10G is an exemplary diagram (part3) of a screen of an operation content setting.
FIG. 10H is an exemplary diagram (part4) of a screen of an operation content setting.
FIG. 11A is a schematic perspective view illustrating a construction of a hand of a second robot.
FIG. 11B is a schematic front view illustrating a construction of a hand of a second robot.
FIG. 11C is a schematic diagram illustrating an operation of a second robot.

### Description of Embodiments

A robot system according to an embodiment of the present application is described below with reference to accompanying drawings. It is not intended that the present invention is limited to those embodiments described below

Hereinafter, it is noted that a subject to be processed is a substrate for an electronic device, on which electronic parts are soldered, although it is not limited thereto. Furthermore, in the following example, a robot system is described, which performs processes including cutting excess lead lines extending from the electronic parts and peeling off a masking tape (adhesive member) that is previously adhered to the substrate as a soldering mask.

Moreover, in the following example, a teaching is mainly described as an exemplary teaching conducted to a robot that performs an operation of peeling off the masking tape. In the following, the above mentioned substrate may be referred to as "workpiece."

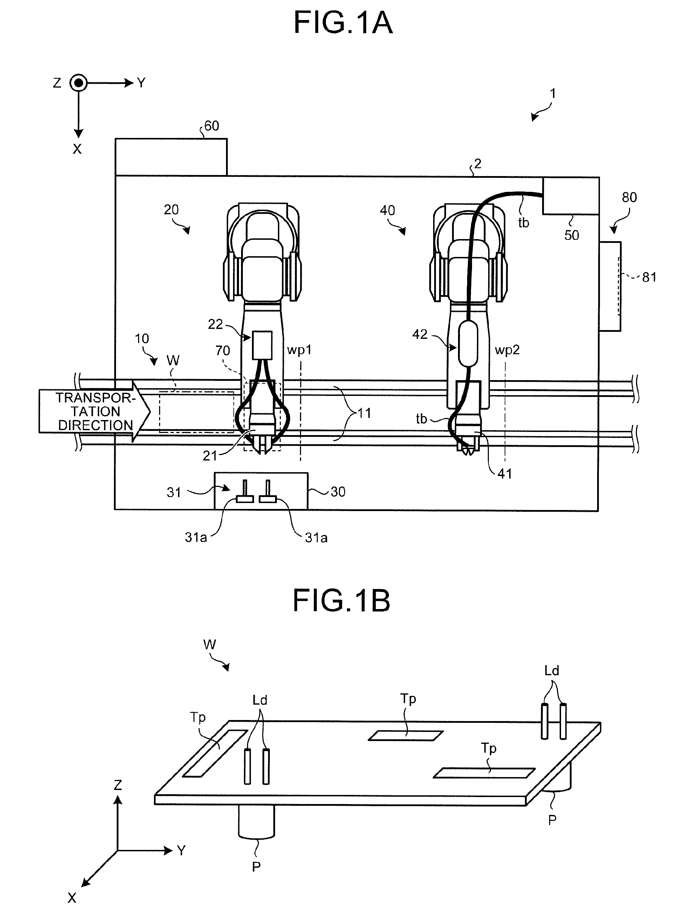

FIG. 1A is a plane view illustrating an entire construction of a robot system 1 according to an embodiment. In FIG. 1A, for the purpose of easy understanding of the description, a 3-dimensional orthogonal coordinate system in which z-axis extends in a vertical direction as upward is positive is depicted. Such orthogonal coordinate system may be used as well in other drawings to which the following description refers. In the present embodiment, it is assumed that x-axis positive direction directs a forward direction with respect to the robot system 1.

As shown in FIG. 1A, a robot system 1 is provided with a cell 2 forming a working space with a cuboid shape. Inside of the cell 2 the robot system 1 is provided with a transportation unit 10, a first robot 20, a tape storage unit 30, a second robot 40, a lead piece storage unit 50, and a camera 70.

Outside of the cell 2 the robot system 1 is provided with a control device 60. The control device 60 is connected to a transportation unit 10, a first robot 20, a second robot 40 and a control panel 80 (mentioned below) in a manner capable of information communication.

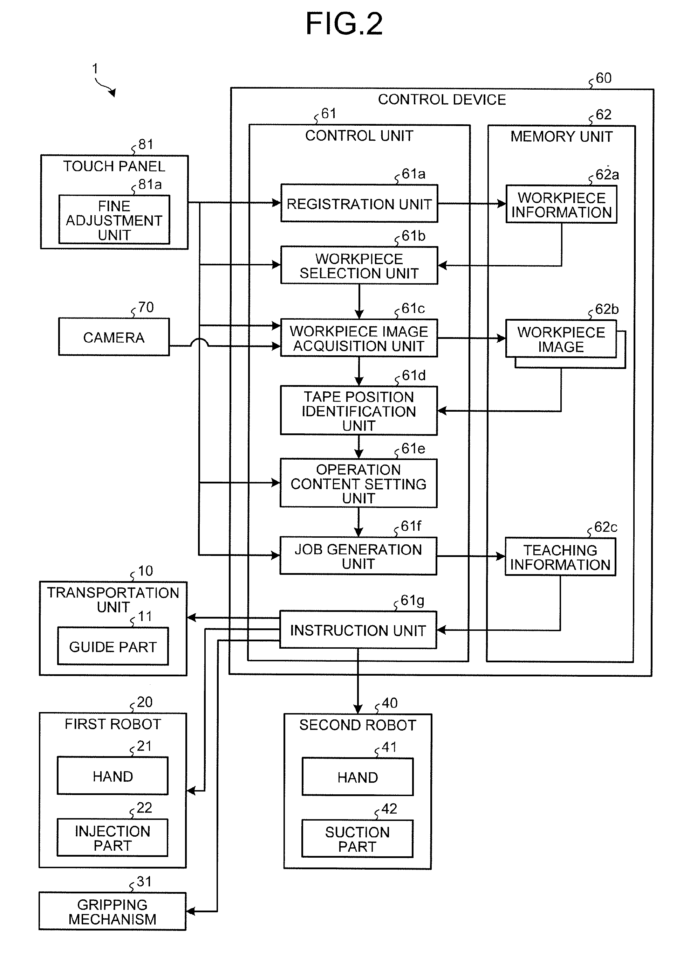

Here, a control device 60 is a controller to control operation of each of devices connected thereto. The control device 60 includes many kinds of control devices, a processing unit, a memory unit and the like. The control device 60 is described in detail with reference to FIG. 2 below.

In FIG.1, a one-case type of control device 60 is illustrated. However, it is not limited thereto. For example, a plurality of cases in which each of the cases is associated with each of devices to be controlled, respectively may be employed. Alternatively, the control device 60 may be located inside of the cell 2.

Furthermore, the robot system 1 is provided with a control panel 80 on an external wall of the cell 2. The control panel 80 is a plate that collectively includes switches, meter devices and the like which are manipulated by an operator, and is provided with a touch panel 81 as a user interface device. The touch panel 81 is display device capable of displaying manipulation parts to be manipulated by the user.

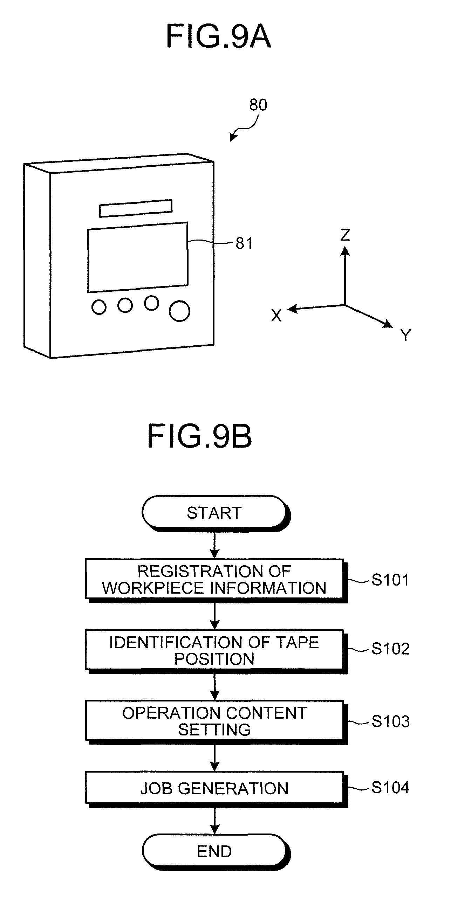

Efficient teaching for a first robot 20 or a second robot 40 is accomplished in the robot system 1 using touch panel 81. Schematic examples of the teaching are described in detail below with reference to FIGS. 9A to 10H.

A transportation unit 10 is arranged along a transportation direction and in parallel therewith in the drawing. The transportation unit 10 includes a pair of guide parts 11 with variable gap therebetween. The transportation unit 10 transports a workpiece W with restricting a movement of the workpiece in a direction of the gap between the pair of guide parts 11 by means of the pair of guide parts 11.

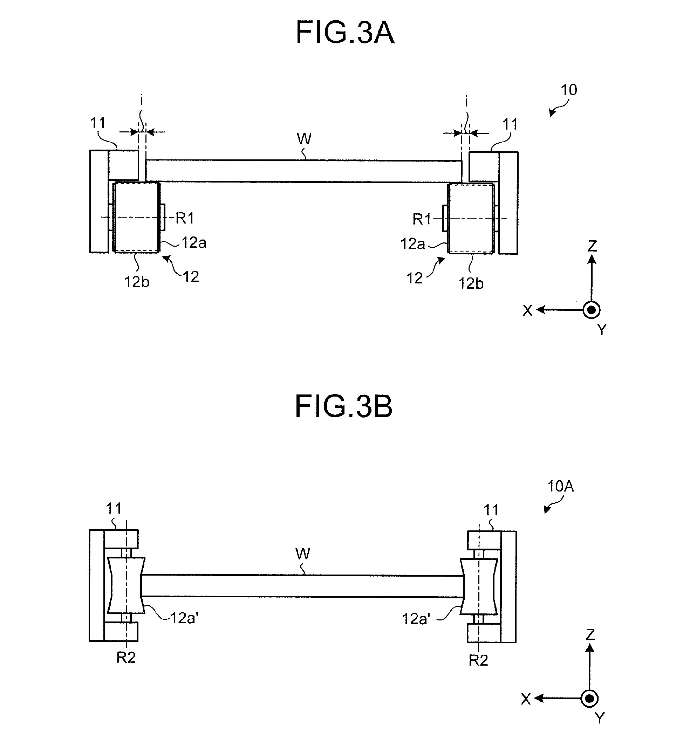

Furthermore, the transportation unit 10 holds the workpiece by grasping it with the pair of guide parts 11 at a working point wp1 of the first robot 20 and at a working point wp2 of the second robot 40. The transportation unit 10 is described in detail below with reference to FIGS. 3A to 4B.

Now, explanation about the workpiece W is provided. FIG. 1B is a schematic diagram of the workpiece W. As shown in FIG. 1B, the workpiece W is a substrate on which electronic parts have been implemented. The workpiece W is transport from prior step with the electronic parts having been implemented plane being oriented downward (negative direction of z-axis). Thus back side of the workpiece being oriented upward (positive direction of z-axis) is subject to process through the robot system 1

As shown in FIG. 1B, masking tape s Tp that have been adhered at prior soldering step for masking and lead lines Ld extending from electric parts P are exposed.

Retuning to FIG. 1A, the first robot 20 is a single arm type manipulator that performs an operation of removing the masking tapes in response to instructions from the control device 60. The first robot 20 is provided with a robot hand 21 (hereinafter, referred to as "hand") at a movable end portion thereof. The hand 21 is provided with a pair of griping claws (mentioned below) to hold an end of the masking tape Tp.

Furthermore, the first robot 20 is provided with an injection part 22 to inject an air from proximity to a tip portion of gripping claw of the hand 21. The first robot 20 peels off the masking tape Tp from the workpiece W using the gripping claws. The first robot 20 causes the peeled masking tape to blow toward the tape storage unit 30 with an air injected from the injection part 22 while gripping the peeled masking tape Tp.

The tape storage unit 30 is a storage part of the masking tape Tp having been peeled off. As shown in FIG. 1A, the tape storage unit 30 is provided with a gripping mechanism 31 which includes the gripping claws 31a. Then, as mentioned above, the first robot 20 brings the masking tape Tp close to the gripping mechanism 31 with the masking tape Tp blowing, and removes the masking tape Tp by causing the gripping mechanism 31 to grip the masking tape Tp.

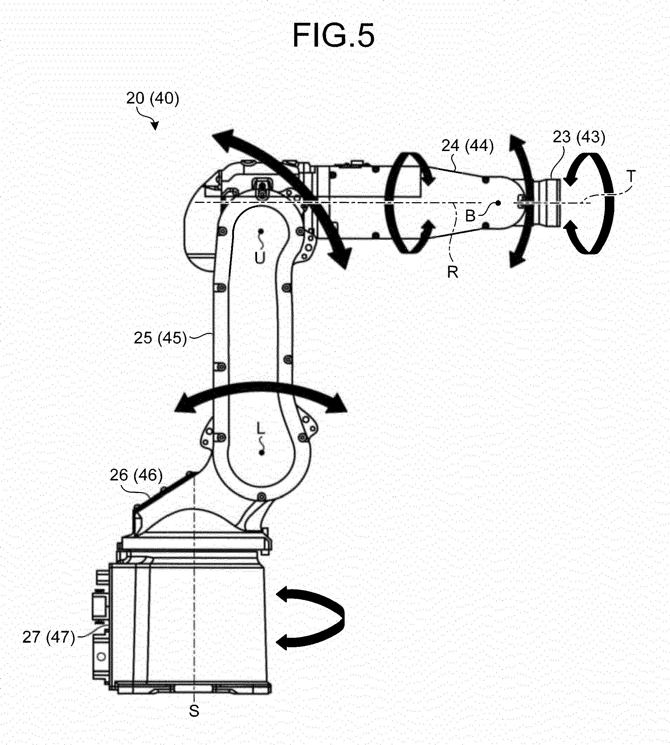

Construction and an operation of the first robot 20 as well as the tape storage unit 30 are described in detail below with reference to FIGS. 5 to 8G.

The second robot 40 is a single arm type manipulator that performs an operation of cutting off an excess lead line Ld extending from the workpiece W in response to instructions from the control device 60. The second robot 40 is provided with a hand 41 at a movable end portion of the arm. The hand 41 is provided with a cutting tool to cut off the lead line Ld. For example, an air nipper is preferable as the cutting tool.

The second robot 40 is further provided with a suction part 42 that suctions a piece of lead line Ld having been cut off (hereinafter, referred to as a lead piece). The suction part 42 includes a suction tube tb communicated with a lead piece storage unit 50. The lead piece storage unit 50 accommodates lead pieces that have been suctioned with the suction part 42 via the suction tube tb.

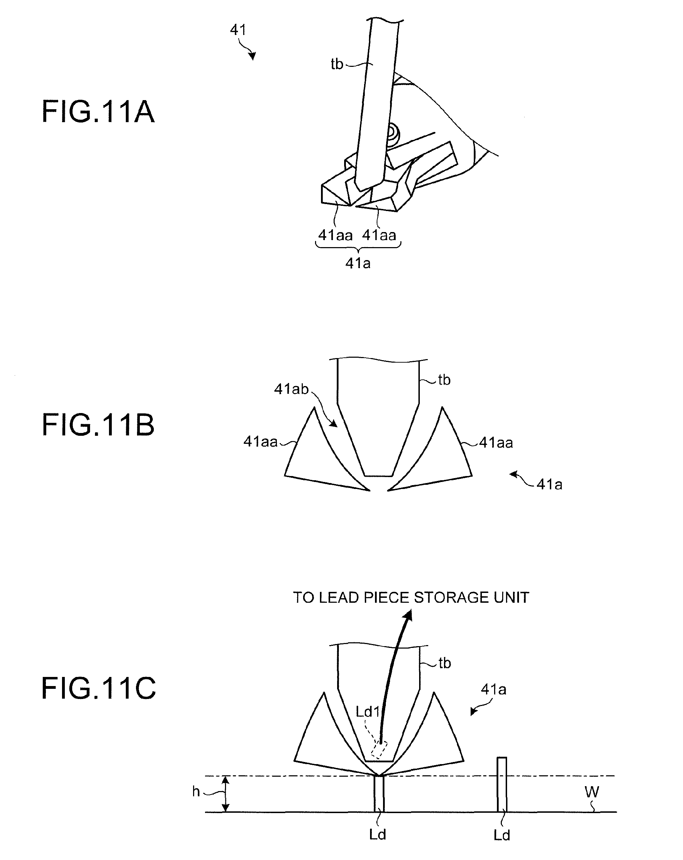

Construction and an operation of the second robot 40 are described in detail below with reference to FIGS. 5 and 11A to 11C.

As shown in FIG. 1A, a camera 70 is provided in vicinity of a hand 21 of the first robot 20, captures an image of the workpiece W in accordance with a manipulation of an operator through touch panel 81, and transmits the captured data to the control device 60. The control device 60 allows the operator to conduct a teaching for the first robot 20 via the touch panel 81 based on the captured image data.

The camera 70 may be provided on a ceiling of the cell 2, for example. The camera may be located in vicinity of the hand 41 of the second robot 40 when the operator conducts a teaching for the second robot 40.

Next, construction of the robot system 1 according to an embodiment is described in a block manner with reference to FIG. 2. FIG. 2 is a block diagram of the robot system 1 according to embodiment. It should be noted that FIG. 2 shows only elements necessary for description of the robot system 1 are depicted with omitting other general elements.

In description with reference to FIG. 2, an internal construction of the control device 60 is mainly described, and thus devices having been described with reference to FIG. 1 may be described lightly.

At the beginning of description of the control device 60, a fine adjustment unit 81a that is provided in the touch panel 81 is described first. The fine adjustment unit 81a is a manipulation part that is displayed together with an actual image of the workpiece W on the touch panel 81, and is provided as an interface capable of making a fine adjustment to a teaching point for the first robot 20.

Namely, the operator is able to make a fine adjustment to a teaching point through the fine adjustment unit 81a while taking a look of an aspect of an actual workpiece W. This point is described in detail below with reference to FIGS. 9A to 10H.

Now, the control device 60 is described. As shown in FIG. 2, the control device 60 includes a control unit 61 and a memory unit 62. The control unit 61 further includes a registration unit 61a, an acquisition workpiece selection unit 61b, a workpiece image acquisition unit 61c, a tape position identification unit 61d (identification part), an operation content setting unit 61e, a job generation unit 61f, and an instruction unit 61g.

The memory unit 62 is a storage device such as a hard disk drive, a non-volatility memory or the like to store a workpiece information 62a, a workpiece image 62b and a teaching information 62c.

All elements shown in FIG. 2 may not be installed in a single control device 60. For example, internal memories of the first robot 20 and the second robot 40 may store either one or all of the workpiece information 62a, a workpiece image 62b and teaching information 62c which are stored in the memory unit 62.

The control unit 61 performs overall control of the control device 60. The registration unit 61a receives registration manipulation for each kinds of workpiece W sent by the operator through the touch panel 81, and causes the memory unit 62 to store it as workpiece information 62a. The workpiece information 62a includes information such as a name or size of the workpiece W to identify a kind of the workpiece W.

The workpiece selection unit 61b obtains from the workpiece information 62a information about the workpiece W used in an operation that is subject to teaching based on selection manipulation by the operator through the touch panel 81.

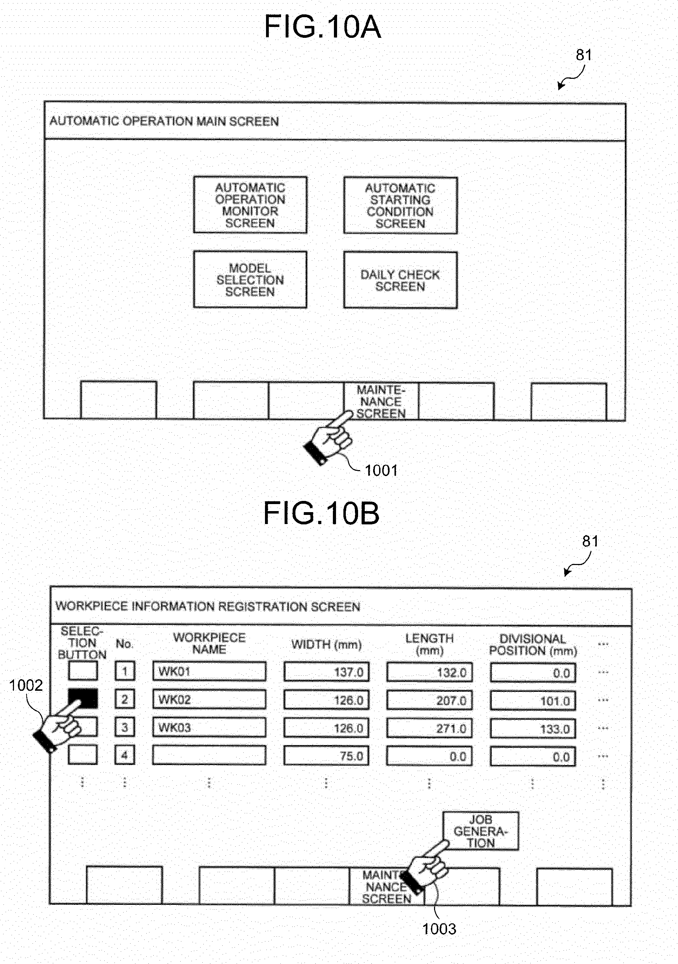

Registration process with a registration unit 61a and workpiece selection process with a workpiece selection unit 61b can be triggered at "workpiece information registration screen" (described below with reference to FIG. 10B) on the touch panel 81.

The workpiece image acquisition unit 61c receives from the camera 70 a captured image with the masking tape Tp being not adhered (image without tapes) and a captured image with the masking tape Tp being adhered (image with tapes) for the workpiece W whose kind is identified by the workpiece selection unit 61b, and causes the memory unit 62 to store the both as workpiece images 62b.

Furthermore, the workpiece image acquisition unit 61c gives notice to the tape position identification unit 61d that the workpiece image acquisition unit 61c has received both of the image without tapes and the image with tapes.

Upon receiving the notice from the workpiece image acquisition unit 61c, the tape position identification unit 61d identifies a position of the masking tape Tp based on difference between an image without tapes and an image with tapes.

The operation content setting unit 61e sets a teaching point for the first robot 20 based on the position of the masking tape Tp, which is identified by the tape position identification unit 61d. Specifically, the operation content setting unit 61e sets an operation contents such as a peeling off start position having been finely adjusted through a fine adjustment unit 81a of the touch panel 81, a direction (a peeling off direction) and an order (a peeling off order) of a masking tape Tp, gives a notice regarding the operation contents to a job generation unit 61f.

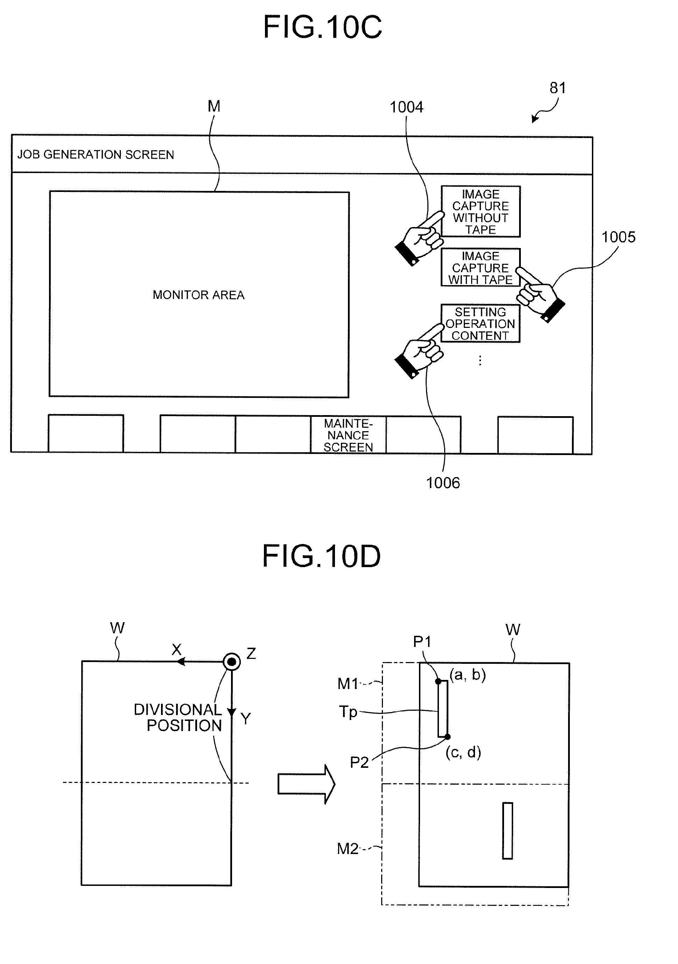

Workpiece image acquisition process by the workpiece image acquisition unit 61c and an operation content setting process by the operation content setting unit 61e can be triggered at "job generation screen" on the touch panel 81 (described below with reference to FIG. 10C).

Upon receiving manipulation by the operator via the touch panel 81, the job generation unit 61f generates "job" on which operation contents having been set by the operation content setting unit 61e are reflected, and causes the memory unit 62 to store it as teaching information 62c.

Here, "job" refers a unique program to cause the first robot 20 to actually operate in accordance with a specific workpiece W. In the present embodiment, it is assumed that program causing the first robot 20 to basically operate in a sequential manner is previously registered in the teaching information 62c. And then "job" is generated by taking operation content set by the operation content setting unit 61e into account as parameters to the program and thus by reflecting the operation content to the program.

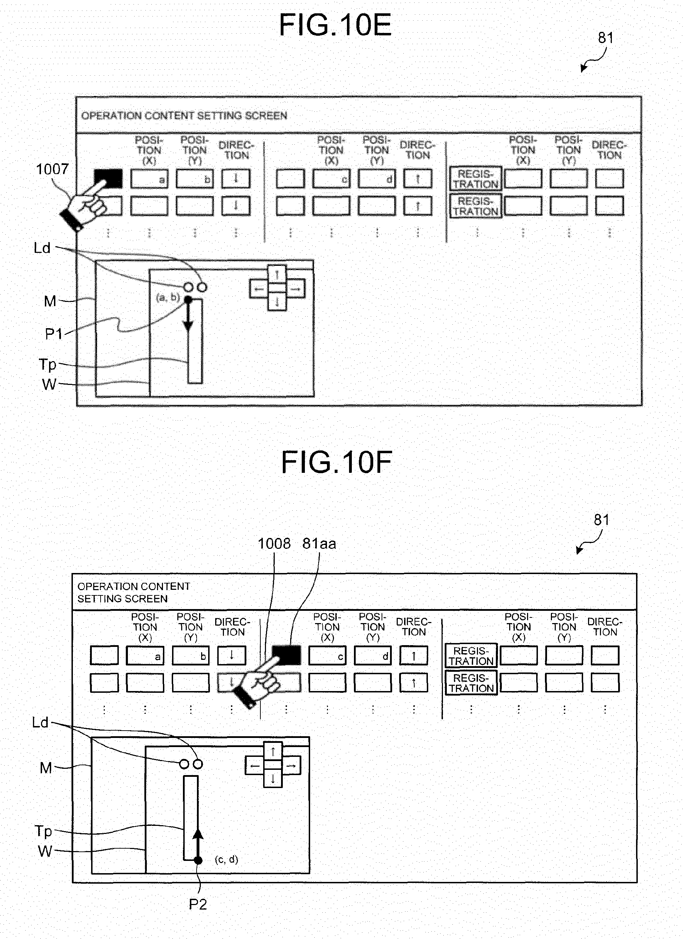

The teaching information 62c may include any programs for devices of the robot system 1 other than the first robot 20. Job generation process by the job generation unit 61f can be triggered at "operation content setting screen" on the touch panel 81 (described below with reference to FIGS.10E to 10H).

The instruction unit 61g generates operation signals based on teaching information 62c generated by the job generation unit 61f to cause any devices such as a transportation unit 10, a first robot 20, a gripping mechanism 31 and a second robot 40a to perform a predetermined process operation, and transmits them to such devices.

Now, construction and operation of each of devices that operate based on instructions from the instruction unit 61g are described in detail. First, construction and operation of the transportation unit 10 are described with reference to FIGS. 3A to 4B.

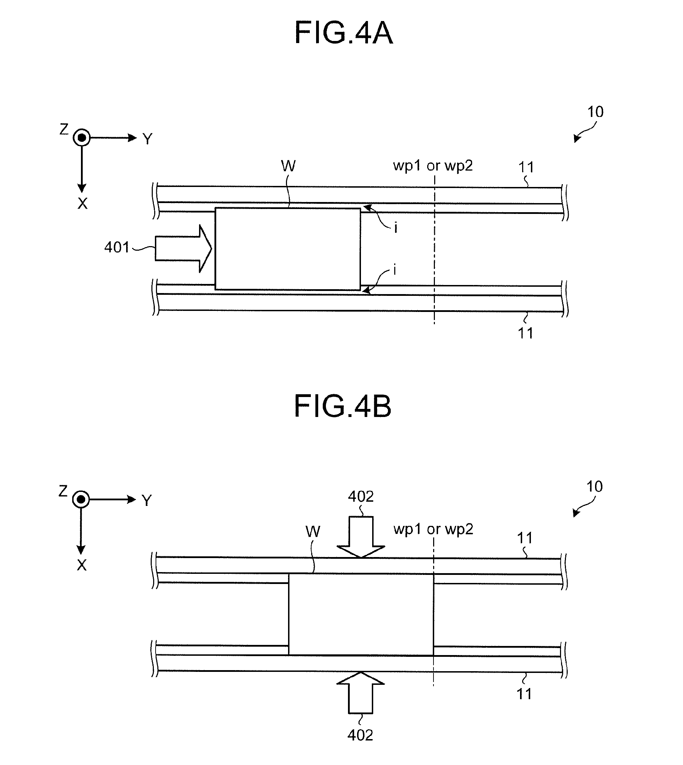

FIGS. 3A and 3B are schematic side views illustrating construction of the transportation unit 10. Although FIGS. 3A and 3B show views from a positive direction of y-axis, they can be deemed as views from a negative direction of y-axis. FIGS. 4A and 4B are schematic plane views illustrating operation of the transportation unit 10.

As shown in FIG. 3A, the transportation unit 10 is arranged along y-axis in parallel and includes a pair of guide parts 11 whose gap is variable.

conveyor unit 12 including a roller part 12a rotatable around a rotation axis R1 in parallel with x-axis and a belt 12b tensively carried by the roller part 12a is provided around each of the guide parts 11. The workpiece W is mounted on the conveyor unit 12 and transported.

As shown in FIG. 3A, during transporting the workpiece W, the transportation unit 10 provides gap i between the workpiece W and the guide part 11, which is within a predetermined range greater than zero in width (for example, around 0.3 mm).

Although in the example shown in FIG. 3A both ends of the workpiece W have a gap I, the workpiece W may be brought into contact with either guide part 11.

Alternatively, as shown in FIG. 3B, it can be constructed as a transportation unit 10A to transport the workpiece W without a gap i. In this case, as shown in FIG. 3B, it is possible to realize the transportation unit 10A by arranging, along the guide part 11, roller parts 12a' rotatable around rotation axes R2 respectively in parallel with z-axis. Namely, in the alternative example of contacting with the workpiece W instead of providing a gap i, the conveyor unit 12 can be adapted slidably.

It is assumed that the robot system according to the present embodiment employs the transportation unit 10 illustrated in FIG. 3A. The instruction unit 61g (see FIG. 2) instructs operations described below to the transportation unit 10.

As shown in FIG. 4A, the instruction unit 61g instructs the transportation unit 10 to perform an operation that the transportation unit 10 transports the workpiece W along a transportation direction as depicted by arrow 401 while restricting the workpiece W with a gap i within an area between the workpiece W and a pair of the guide part 11 until the workpiece W reaches either operation position wp1 or operation position wp2.

As shown in FIG. 4B, when the workpiece W reaches either operation position wp1 or operation position wp2, the instruction unit 61g instructs the transportation unit 10 to perform an operation that the transportation unit 10 holds the workpiece W by causing the pair of guide part 11 to grip the workpiece W in a direction substantially orthogonal to the transportation direction (i.e., x-axis direction, see arrow 402). Alternatively, one of the guide parts 11 may be driven so that the workpiece W is pressed to the other guide part 11.

In this way, operation of gripping the workpiece W can be performed by interconnecting the pair of the guide part 11 with a spline shaft for example.

Thereby, it is possible to surely fix the workpiece W at either the operation position wp1 or operation position wp2. Therefore, it is accomplished to prevent the workpiece W from displacement during operation, and to improve accuracy of process performed by the second robot 40. Namely, it is ensured that a process operation using a robot comes more reliable.

Construction and operation of the first robot 20 as well as construction of the tape storage unit 30 are described with reference to FIGS. 5 to 8G. First, FIG. 5 is a schematic side view illustrating the construction of the first robot 20.

FIG. 5 also shows a schematic side view illustrating construction of the second robot 40. In this embodiment, the first robot 20 is the same type as the second robot 40. In FIG. 5, numerical number with notation ( ) indicates elements of the second robot 40 corresponding to elements of the first robot. It is not intend to exclude that the first robot 20 is different type from the second robot 40.

As shown in FIG. 5, the first robot 20 is a single arm type multi-axis robot. Specifically, the first robot 20 includes a first arm part 23, a second arm part 24, a third arm part 25, a fourth arm part 26 and a base part 27.

The first arm part 23 is supported at its base end by the second arm part 24. The second arm part 24 is supported at its base end by the third arm part 25, and supports at its tip end the first arm part 23.

The third arm part 25 is supported at its base end by the fourth arm part 26, and supports at its tip end the second arm part 24. The fourth arm part 26 is supported at its base end by the base part 27 secured to a floor of a working room for example, and supports at its tip end the third arm part 25.

Each of joint parts (not shown) which is an interconnection part interconnecting the first arm part 23 through the base part 27 installs an actuator. The first robot 20 performs a multi-axis operation according to a drive of the actuator that is controlled by the instruction unit 61g.

Specifically, an actuator of a joint part that interconnects the first arm part 23 and the second arm part 24 causes the first arm part 23 to rotate around B-axis. An actuator of a joint part that interconnects the second arm part 24 and the third arm part 25 causes the second arm part 24 to rotate around U-axis.

An actuator of a joint part that interconnects the third arm part 25 and the fourth arm part 26 causes the third arm part 25 to rotate around L-axis.

An actuator of a joint part that interconnects the fourth arm part 26 and the base part 27 causes the fourth arm part 26 to rotate around S-axis.

Furthermore, the first robot 20 independently includes an actuator that causes the first arm part 23 to rotate around T-axis and an actuator that causes the second arm part 24 to rotate around R-axis. Namely, the first robot 20 has six (6) axes.

A tip end portion of the first arm part 23 is a movable end of the first robot 20 to which a hand 21 is adapted. Now, the hand 21 is described.

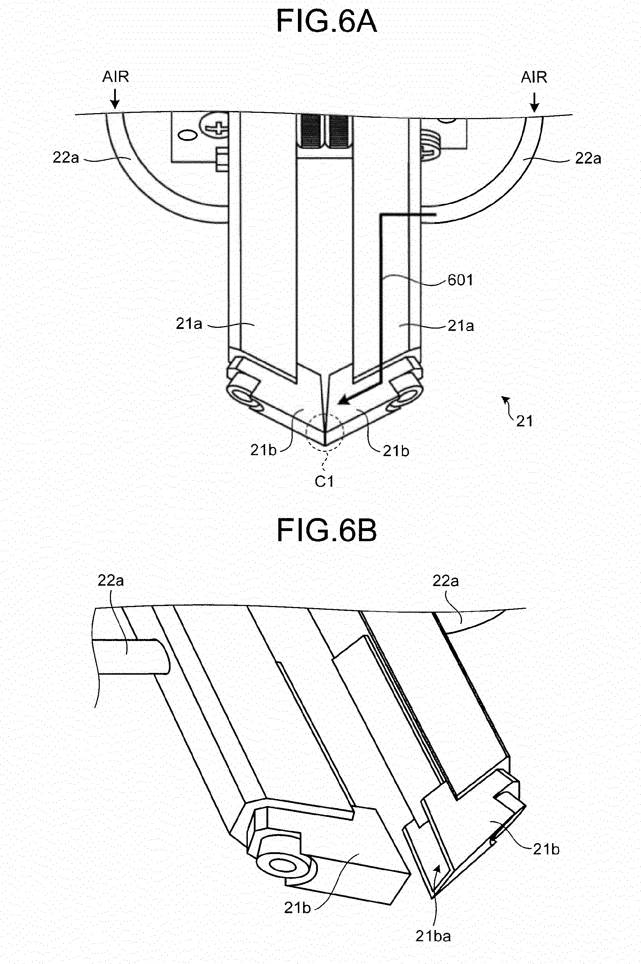

FIG. 6A is a schematic front view illustrating construction of the hand 21 of the first robot 20. FIG. 6B is a schematic perspective view illustrating construction of the hand 21 of the first robot 20.

As shown in FIG. 6A, the hand 21 is provided with a pair of open-close parts 21a. A gripping claw 21b which is a grip member to grip the masking tape Tp is provided at a tip end of each of the open-close parts 21a.

FIG. 6A shows a state where a pair of the open-close parts 21a is closed. The gripping claws 21b have a shape with an obliquely truncated acute angle such that tip end portions thereof are contact with each other in a line when the pair of the open-close parts 21a is closed (see a portion surrounded by circle C1).

Thereby, it is possible to reduce an area that contacts with an adhesive plane of a masking tape in gripping the masking tape Tp. Accordingly, it makes the masking tape Tp hard to adhere and thus easy to remove. Namely, it is ensured that a process operation using a robot comes more reliable.

In addition, it is possible to reduce an area that contacts with the workpiece W when peeling off the masking tape Tp. It allows for being hard to scratch the workpiece W. Preferably, the gripping claw 21b is made of a soft material such as a resin. Thereby, it also allows for being hard to scratch the workpiece W.

As shown in FIG. 6A, each of open-close parts 21a is connected with a nozzle 22a which is a passage of air supplied from the injection part 22. Each of the open-close parts 21a has a hollow structure with the gripping claw 21b side end being opened to flow an air supplied through the nozzle 22a along a passage as depicted by arrow 601.

As shown in FIG. 6B, each of opposite planes of the gripping claws 21b has a recess part 21ba to expose an inner wall outside. An air flowing inside the open-close part 21a is injected through the recess part 21ba from a tip portion of each of the gripping claws 21b.

By arranging the air passage in this way, it is possible to prevent a grip operation of the hand 21 from being obstructed by interference between the injection mechanism such as the injection part 22 and the open-close part 21a or the gripping claw 21b.

Furthermore, by injecting an air from a tip portion of each of the gripping claws 21b, it is possible to surely blow the peeled-off masking tape Tp without curling up, thereby making it easy to remove. Namely, it is ensured that a process operation using a robot comes more reliable.

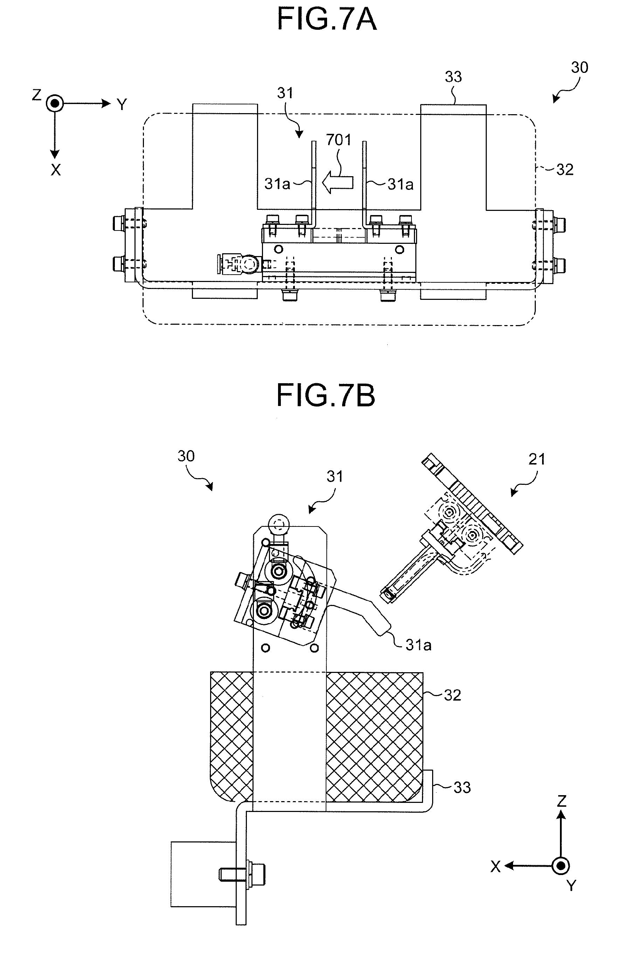

Next, the tape storage unit 30 is described. FIG. 7A is a schematic plane view illustrating construction of the tape storage unit 30. FIG. 7B is a schematic side view illustrating construction of the tape storage unit 30.

As shown in FIGS. 7A and 7B, the tape storage unit 30 includes a gripping mechanism 31, a basket part 32 and a pedestal part 33. The gripping mechanism 31 includes a pair of gripping claws 31a. The pair of gripping claws 31a is provided so as to be capable of open-close operation along y-axis.

In this embodiment, as depicted by arrow 701, open-close operation is performed by causing only one of the gripping claws 31a to be movable. However, open-close operation may be performed by causing both of the gripping claws 31a to be movable.

The gripping mechanism 31 is provided being fixed to the pedestal part 33. A basket part 32 is adapted to the pedestal part 33. The basket part 32 is a basket to accommodate a removed masking tape Tp.

As shown in FIG. 7B, after removing the masking tape Tp by the hand 21, the first robot 20 brings the hand 21 close to the gripping mechanism 31 while causing the masking tape Tp to blow. Then, the first robot 20 causes the gripping claw 31a of the gripping mechanism 31 to grip the masking tape Tp.

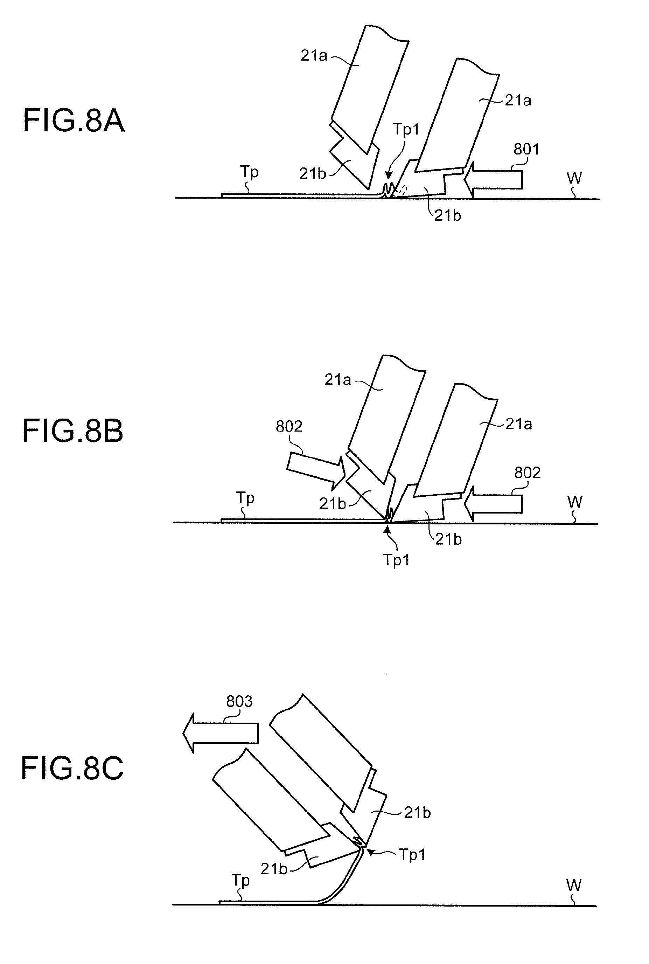

Next, a sequence of operation, operation of the first robot 20 instructed by an instruction unit 61g after the workpiece W is fixed at an operation position wp1, is described. FIGS. 8A to 8G are schematic diagrams (part1 to part7) illustrating operation of the first robot 20 and the gripping mechanism 31.

As shown in FIG. 8A, the instruction unit 61g instructs the first robot 20 to perform an operation including opening the pair of open-close part 21a, and scratching up an end of masking tape Tp while abutting one of the gripping claws 21b on the workpiece W (see arrow 801). Here, a notation Tp1 refers the end of the masking tape Tp that has been scratched up through the operation. In operation of scratching up, the gripping claws 21b may be swung.

As shown in FIG. 8B, the instruction unit 61g instructs the first robot 20 to perform an operation including closing the pair of open-close part 21a, and gripping an end of masking tape Tp that has been scratched up by the gripping claws 21b (see arrow 802).

As shown in FIG. 8C, the instruction unit 61g instructs the first robot 20 to perform an operation of scratching up an end of masking tape Tp while gripping an end of masking tape Tp that has been scratched up by the gripping claws 21b (see arrow 803).

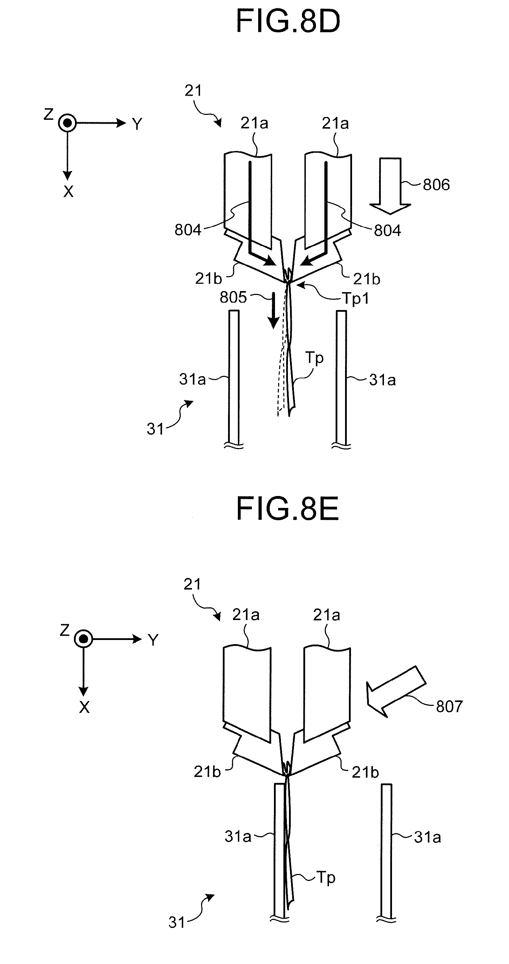

As shown in FIG. 8D, the instruction unit 61g instructs the first robot 20 to perform an operation including directing a tip portion of the gripping claws 21b toward gripping claws 31a of the gripping mechanism 31, and injecting an air from the tip portion of the gripping claws 21b while gripping the end of masking tape Tp (see arrow 804).

In this way, it is possible to cause the peeled-off masking tape Tp to blow without curling up. Then, the instruction unit 61g instructs the first robot 20 to perform an operation of bringing a hand 21 close to the gripping mechanism 31 while blowing the masking tape Tp (see arrow 806).

As shown in FIG. 8E, the instruction unit 61g instructs the first robot 20 to perform an operation of bringing a hand 21 closer to the gripping mechanism 31 such that a blowing masking tape Tp comes into touch with one of the gripping claws 31a (see arrow 807). In this way, it is possible to improve a certainty of grip of the masking tape Tp with the pair of gripping claws 31a by causing the masking tape Tp to contact with one of the gripping claw 31a. Namely, it is ensured that a process operation using a robot comes more reliable.

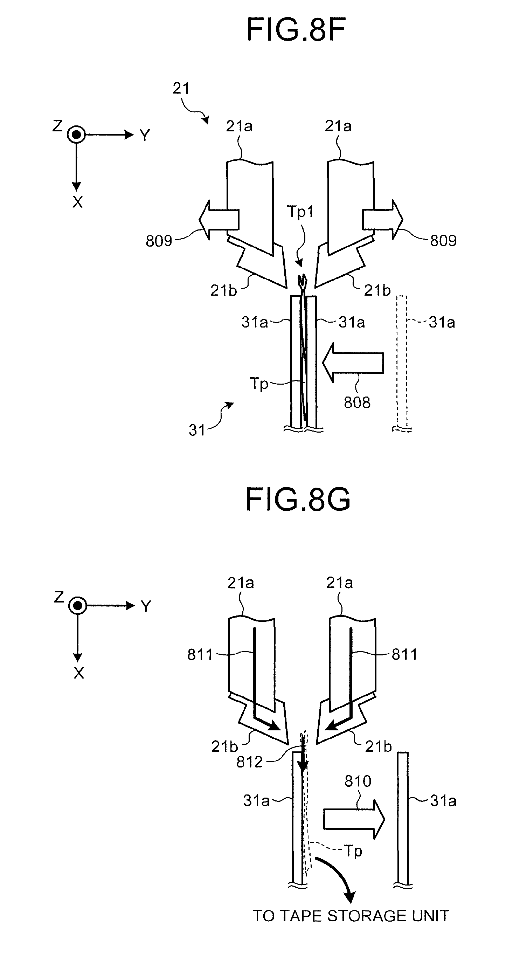

In FIG. 8E, an air flow is not shown, but it is assumed that an air is continuously injected from a tip portion of each of the gripping claws 21b. The same thing can be applied in FIG. 8F described below.

As shown in FIG. 8F, the instruction unit 61g instructs the gripping mechanism 31 to perform an operation of closing the pair of the gripping claws 31a to grip the masking tape Tp (see arrow 808).

Also, the instruction unit 61g instructs the first robot 20 to perform an operation of opening the pair of the gripping claws 31a and releasing an end portion of the masking tape Tp after the gripping mechanism 31 grips masking tape Tp (see arrow 809). Thereby, it is possible to surely peel off the masking tape Tp from the hand 21. Namely, it is ensured that a process operation using a robot comes more reliable.

As shown in FIG. 8G, the instruction unit 61g instructs the gripping mechanism 31 to perform an operation of opening the pair of the gripping claws 31a to release the grip of the masking tape Tp (see arrow 810).

Thereby, a released masking tape Tp is blown away toward a tape storage unit 30 upon receiving an air being injected from the tip portion of the gripping claws 21b (see arrow 811 and arrow 812), and then is accommodated into a basket part 32 of the tape storage unit 30.

The instruction unit 61g instructs the first robot 20 and the gripping mechanism 31 to repeat a sequence of operations shown in FIGS. 8A to 8G until all of the masking tape Tp to be removed are removed from the workpiece W.

Such instructions by the instruction unit 61g are provided based on the teaching information 62c that is generated as a job associated with a teaching that is previously conducted by the operator as mentioned above. In this embodiment, the teaching can be easily conducted through a control panel 80 without using such a programing pendant or the like while confirming an actual status of the workpiece W.

Next, specific examples of the teaching are described below with reference to FIGS. 9A to 10H. First, FIG. 9A is a schematic perspective view illustrating construction of the control panel 80. As shown in FIG. 9A, the control panel 80 includes a touch panel 81. A teaching according to the embodiment is performed via the touch panel 81.

Operator is able to perform the teaching in an intuitive and simple manner, so that it meets a requirement of an efficient teaching. Even if the operator is not so skilled, he/she can manipulate the system in an intuitive manner, so that it meets a requirement of reduction of human relative costs.

Next, FIG. 9B is a flowchart illustrating a flow of operation procedures of a teaching according to the embodiment. As shown in FIG. 9B, in the embodiment, a registration of workpiece information 62a is made first, (step S101). This registration procedure corresponds to a registration process by the registration unit 61a and a workpiece selection operation by the workpiece selection unit 61b as above mentioned.

Subsequently, a tape position is identified (step S102). This identification procedure corresponds to a workpiece image acquisition process by the workpiece image acquisition unit 61c and a tape position identification process by the tape position identification unit 61d as above mentioned.

Namely, for the workpiece W selected in step S101, a position to which the masking tape Tp is adhered can be identified by getting the difference between an image without a tape and an image with a tape.

Subsequently, an operation content is set (step S103). This operation content setting procedure corresponds to an operation content setting process by the operation content setting unit 61e. Specifically, which position of masking tapes Tp should be removed in what order and from what direction, and what degree of fine adjustment should be made to peeling off position of the masking tape Tp.

Subsequently, a job is generated (step S104). This job generation procedure corresponds to a job generation process by the job generation unit 61f as above mentioned. Namely, a unique program causing the first robot 20 to actually operate is automatically generated based on the operation content set in the step S103.

Operation procedures of steps S101 to S104 are described with reference to examples of the screen displayed on the touch panel 81. FIG. 10A illustrates one of the examples of a main screen. For example, the main screen is displayed as "automatic operation main screen" when the robot system 1 is under a common automatic operation.

Then, in performing a teaching, when an operator makes a touch on a button shown at "maintenance screen" of the "automatic operation main screen", the screen transits to "workpiece information registration screen" (see operation 1001).

FIG. 10B illustrates one of the examples of a workpiece information registration screen. As shown in FIG. 10B, on the workpiece information registration screen, input/output items indicating characteristics of the workpiece such as "No.", "workpiece name", "width", "length", "divisional position" are displayed. In this example, each of kinds of workpiece W corresponds to each of rows, respectively. The "divisional position" is described below with reference to FIG. 10D.

An operator is able to register the workpiece W according to the kind thereof through the workpiece information registration screen. Then, registered content input via the workpiece information registration screen is transmitted to the control device 60 to be stored as workpiece information 62a.

As shown in FIG. 10B, a selection button that is indicated as "selection button" is provided at a head of row. The operator selects a workpiece used as a subject to be processed in operation that comes into being subject to a teaching by making a touch operation on the selection button (see operation 1002). Here, for the convenience of explanation, a selection button under operation 1002 is colored in black as the button has been touched. The same thing is applied to FIG. 10C and further.

Then, when an operator makes a touch on a button shown as "job generation", the screen transits to "job generation screen" for operation procedures such as step 102 and the like (see operation 1003).

FIG. 10C illustrates one of the examples of a job generation screen. As shown in FIG. 10C, the job generation screen includes a monitor area M, "image acquisition without tape" button, "image acquisition with tape" button, and "operation content setting" button.

The monitor area M is a display area of a workpiece image that corresponds to actual image capturing area of a camera 70. If the operator makes a touch on "image acquisition without tape" button (see operation 1004), image without tape of the workpiece W is obtained by the workpiece image acquisition unit 61c.

Similarly, if the operator makes a touch on "image acquisition with tape" button (see operation 1005), image with tape of the workpiece W is obtained by the workpiece image acquisition unit 61c.

Here, with respect to image capturing of the workpiece W, the above mentioned "divisional position" (see FIG. 10B) is described with reference to FIG. 10D.

FIG. 10D is a schematic diagram illustrating the divisional position. As shown in left side of FIG. 10D, a particular point of the workpiece W in a main plane can be represented by an orthogonal coordinate system in which the origin is one of the apexes for example.

Furthermore, there is a case that the workpiece W does not fall in an image capture area and thus a monitor area M for its size. Therefore, the workpiece image acquisition unit 61c acquires an image data of the workpiece W captured by the camera 70 for each of divisional areas M1 and M2 divided at the predetermined "divisional position" if the workpiece W does not fall in the monitor area M (see right side of FIG. 10B).

The position of the masking tape Tp is identified for each of divisional areas M1 and M2 by the tape position identification unit 61d.

Here, for the convenience of explanation, as shown in right side of FIG. 10D, an apex P1 and an apex P2 of the masking tape Tp in divisional area M1 are identified as (a, b) and (c, d) in x-y coordinate system, respectively.

Retuning to FIG. 10C, when an operator makes a touch on "operation content setting" button (see operation 1006), the screen transits to "operation content setting screen" for operation procedures such as step 103.

FIGS. 10E to 10H illustrate examples (part1 to part4) of an operation content setting screen. As shown in FIG. 10E, the operation content setting screen includes three of groups consisting of "position(X)", "position(Y)" and "direction" as well as a monitor area M.

The first group on the left side shows a position of the above mentioned apex P1 in x-y coordinate system and a peeling off direction from the apex P1. Similarly, the second group in the middle shows a position of the above mentioned apex P2 in x-y coordinate system and a peeling off direction from the apex P2. The third group on the right side shows a peeling off position and a peeling off direction of the masking tape Tp that are to be finally registered.

As shown in FIG. 10E, for the first and the second groups, positions identified by the tape position identification unit 61d are automatically input. It is assumed that as operation 1007 a selection button of the first group is touched. In this case, arrow that extends downward from an apex P1 is displayed in the monitor area M overlapping with an actual image with tape of the workpiece W.

If peeling off the masking tape downward from the apex P1, as the image with tape in the monitor area M shows that there is a lead line Ld in vicinity of the apex P1, it can be predicted that a quality of operation is degraded due to interference between a hand 21 and lead line Ld.

Therefore, in such a case, an operator as operation 1008 shown in FIG. 10F makes a touch on a selection button 81aa of the second group to change a peeling off position and a peeling off direction on the basis of the apex P1 with a peeling off position and a peeling off direction on the basis of the apex P2. For the purpose of clear viewing, an arrow that extends upward from an apex P2 is displayed in the monitor area M overlapping with an actual image with tape of the workpiece W. It should be noted that the selection button 81aa is mere an example of the fine adjustment unit 81a.

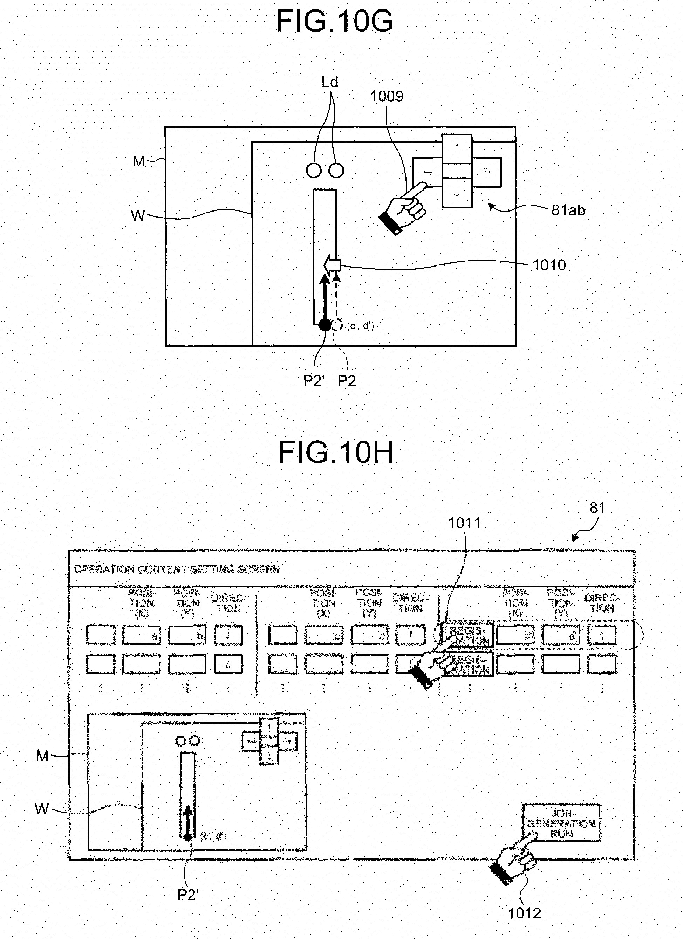

The peeling off position of the masking tape Tp can be more finely adjusted. Namely, as shown in FIG. 10G, a fine adjustment button 81ab consisting of "←", "↑", "→" and "↓" is arranged in the monitor area M. It should be noted that the fine adjustment button 81ab is also an example of the fine adjustment unit 81a.

If an operator makes a touch on "←" button of the fine adjustment button 81ab (see operation 1009), the arrow that extends upward from an apex P2 slides to a left direction and thereby assisting the operator in fine adjustment visibly (see operation 1010). It this way, the operator is able to perform a fine adjustment in an intuitive and simple manner. Namely, it meets a requirement of an efficient teaching.

Furthermore, it meets a requirement of an accurate teaching since the operator is able to perform the teaching viewing an actual aspect of the workpiece W displayed in the monitor area M.

As shown in FIG. 10G, in case of conducting a fine adjustment so as to move the peeling off position from a tip portion of the masking tape Tp to a substantial middle in a width direction, it allows for equally adding a force to the masking tape Tp and thus ensuring ease to peel off it. Namely, it is ensured that a process operation using a robot comes more reliable.

Then, as shown in FIG. 10H, an operator makes a touch on "register" button of the third group (see operation 1011), thereby a peeling off position and direction of the masking tape Tp are decided.

After peeling off positions and directions with respect to all of the masking tape Tp are decided, it is deemed that the operator makes a touch on "job generation run" button (see operation 1012). In this way, the job generation unit 61f generates a job based on all of the peeling off positions and directions that are provided as parameters from the operation content setting unit 61e as well as basic program that is previously registered in the teaching information 62c.

Next, construction and operation of a second robot 40 are described with reference to FIGS. 11A to 11C. With respect to the second robot 40, because a construction of the second robot 40 is the same as that of the first robot 20 described with reference to FIG. 5, a detail explanation is omitted. An explanation of a hand 41 is disclosed that is adapted to a movable end (first arm part 43, see FIG. 5) of the second robot 40.

FIG. 11A is a schematic perspective view illustrating construction of the hand 41 of the second robot 40. FIG. 11B is a schematic front view illustrating construction of the hand 41 of the second robot 40. FIG. 11C is a schematic diagram illustrating operation of the second robot 40.

As shown in FIG. 11A, the hand 41 is provided with a nipper 41a including a pair of blade parts 41aa. The nipper 41a is a tool capable of cutting an excess lead line Ld of the workpiece W. Taking into account of using a manipulator instead of a human finger, an air nipper is preferable as the nipper 41a.

Furthermore, the hand 41 includes a suction tube tb that is interconnected to a lead piece storage unit 50 (see FIG. 1) through the suction part 42 (see FIG. 1) that suctions a piece of lead line.

As shown in FIG. 11B, a tip portion of the suction tube tb has pursed shape. In this way, as shown in FIG. 11B, it is possible to arrange a tip portion of the suction tube tb in a deeper position of a recess part 41ab formed by a pair of the blade parts 41aa. Accordingly, it can result in a sure suction of the piece of lead line immediately after having been cut. Namely, it is ensured that a process operation using a robot comes more reliable.

Next, operation of the second robot 40 to be instructed be the instruction unit 61g after the workpiece W is fixed at an operation positon wp2 is described below.

As shown in FIG. 11C, the instruction unit 61g instructs the second robot 40 to perform an operation including cutting an excess of a lead line that extends from the workpiece W over a predetermined height h (for example, around 3 mm) by means of a nipper 41a and driving a suction part 42.

Namely, at the same time of cutting by means of the nipper 41a, a lead piece storage unit 50 applies a suction force to the piece of lead line Ld. In this way, it is possible to suction the piece of lead line immediately after it occurs. As a result, it is ensured that a process operation using a robot comes more reliable.

Then, the instruction unit 61g instructs the second robot 40 to repeat operations shown in FIG. 11C until all of lead line Ld to be cut are cut.

Subsequently, the instruction unit 61g instructs the transportation unit 10 to transport the workpiece W to an outside following step outside of a cell 2 when a processing operation of the workpiece W at the second robot 40 is completed.

As described above, a robot system according to embodiment includes a touch panel (display device), a camera, a tape position identifying unit (identification part), a fine adjustment unit and an instruction unit. The camera captures both an image with a masking tape (member) to be handled and an image without a masking tape on the workpiece. The tape position identifying unit identifies a position of the masking tape based on data captured by the camera. The fine adjustment unit is provided as an interface in which an operator is able to conduct a fine adjustment of a teaching point for a robot on the basis of a position of the masking tape while viewing the workpiece W displayed on a touch panel. The instruction unit instructs a robot to perform an operation for a predetermined process based on teaching information that have been generated by reflecting the teaching point that has been finely adjusted through the fine adjustment unit.

As a result, a robot system according to the embodiment can achieve both of efficient and accurate teaching, and reliability of the process operation of the robot.

In the embodiment above mentioned, teaching to the first robot is exemplarily described. However, of course, the teaching according to the embodiment may be applied to the second robot.

Similar to a case of the first robot, operation content may be set by identifying a position of the lead line based on data captured by the camera, and finely adjusting the teaching position on the basis of the identified position using a touch panel independently. Then, teaching may be performed to the second robot by generating a job based on the operation content having been set via a touch panel.

Furthermore, in the embodiment above mentioned, touch panel is exemplarily described as a user interface device an operator uses. However, it is not limited thereto if it is possible to conduct a fine adjustment while capturing image of an actual workpiece. For example, an input device provided with operation buttons and the like as hardware may be combined with a display device.

Furthermore, in the embodiment above mentioned, a workpiece to be processed is exemplarily described as a substrate on which electronic parts have been soldered in a previous step. However, it is not limited thereto. A workpiece with any kind or any shape may be employed if it is possible to transport and grip with a transportation unit.

Furthermore, in the embodiment above mentioned, a single arm type robot is exemplarily described. However it is not limited thereto. A multi-arm type robot with more than two arms may be employed. For example, in a case of employing a double-arm type robot, it may be constructed such that a hand of one arm may remove a masking tape while a hand of the other arm may cut a lead line.

Furthermore, in the embodiment above mentioned, adhesive material such as a masking tape is exemplarily described as a member to be handled by a robot. However material is not limited thereto. Namely, it may be non-adhesive material such as a lead line to be handled by the second robot.

Furthermore, in the embodiment above mentioned, multi-axis robot that has 6 axes every arm is exemplarily described as a robot. However the number of axis is not limited thereto.

Furthermore, in the embodiment above mentioned, a pair of grip claws of a hand or a grip mechanism is exemplarily described. However it is not limited thereto if it is more than two pairs of grip claws.

Furthermore, in the embodiment above mentioned, it is assumed that a skilled operator conducts a teaching. However, the operator may be not skilled person.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

### Reference Signs List

1 robot system, 2 cell, 10 transportation unit, 10A transportation unit, 11 guide part, 12 conveyer unit, 12a belt, 12b belt, 20 first robot, 21 hand, 21a open-close port, 21b gripping part, 21ba recess part, 22 injection part, 22a nozzle, 23 first arm part, 24 second arm part, 25 third arm part, 26 fourth arm part, 27 base part, 30 tape storage unit, 31 gripping mechanism, 31a gripping claw, 32 basket part, 33 pedestal part, 40 second robot, 41 hand, 41a nipper, 41aa blade part, 41ab recess part, 42 suction part, 50 lead piece storage unit, 60 control device, 61 control unit, 61a registration unit, 61b workpiece selection unit, 61c workpiece image acquisition unit, 61d tape position identification unit, 61e operation content setting unit, 61f job generation unit, 61g instruction unit, 62 memory unit, 62a workpiece information, 62b workpiece image, 62c teaching information, 70 camera, 80 control panel, 81 touch panel, 81a fine adjustment unit, 81aa selection button, Ld lead line, Ld1 lead piece, P electronic parts, Tp masking tape, Tp1 end portion, W workpiece, tb suction tube, wp1 operation position, wp2 operation position.

## Claims

1. A robot system comprising:
a display device;
a camera that captures an image of a workpiece with a member thereon and an image of the workpiece without the member thereon, the member being a target to be handled by a robot;
an identification unit configured to identify a position of the member on the basis of image data captured by the camera;
a fine adjustment unit provided as an interface by which an operator conducts a fine adjustment of a teaching point for the robot based on the position of the member while viewing the workpiece displayed on the display device; and
an instruction unit configured to instruct the robot to perform an operation for a predetermined process on the basis of teaching information generated by reflecting the teaching point finely adjusted through the fine adjustment unit.

2. The robot system according to claim 1, wherein
the member is adhesive material,
the robot further comprises a robot hand provided with a pair of gripping claws that grips the adhesive material adhered on the workpiece, and
the instruction unit instructs the robot to perform an operation of peeling off the adhesive material while gripping an end portion of the adhesive material by using the gripping claws.

3. The robot system according to claim 2, wherein the fine adjustment unit is provided so that a peeling off position at which the adhesive material is first peeled off is finely adjustable and so that a peeling off direction to which the adhesive material is peeled off is changeable.

4. The robot system according to claim 2 or 3, further comprising a gripping mechanism that further grips the adhesive material, which is peeled off by the robot and is gripped by the robot hand, and removes the adhesive material from the robot hand.

5. The robot system according to claim 4, further comprising an injection mechanism that injects air from near a tip portion of the gripping claw, wherein
the instruction unit instructs the robot to perform an operation of injecting the air from the injection mechanism with the peeled-off adhesive material being gripped to cause the adhesive material to blow toward the gripping mechanism and of bringing the robot hand close to the gripping mechanism, and
the instruction unit instructs the gripping mechanism to perform an operation of gripping the adhesive material blowing from the robot hand brought close to the gripping mechanism by the robot and removing the adhesive material.

6. The robot system according to claim 5, wherein
the gripping mechanism includes a pair of gripping claws that grips a blowing adhesive material, and
the instruction unit instructs the robot to perform an operation of further bringing the robot hand closer to one of the gripping claws so that the adhesive material comes into touch with one of the gripping claws of the gripping mechanism.

7. The robot system according to claim 1, wherein
the display device includes a touch panel, and
the fine adjustment unit is provided as a manipulation part displayed on the display device.

8. The robot system according to claim 1, wherein the camera captures an image of the workpiece for each of divisional areas divided at a predetermined divisional position when a size of the workpiece does not fall within a capture area of the camera.
